# EUROPÄISCHE PATENTSCHRIFT

(11) **EP 1 594 167 B1**
(45) Veröffentlichungstag und Bekanntmachung des Hinweises auf die Patenterteilung: **17.01.2007**
(21) Anmeldenummer: 04010490.3
(22) Anmeldetag: 03.05.2004
(51) Int. Cl.: H01L 31/02, H01L 23/552

(54) **Optoelektronischer Empfänger**
Optoelectronic receiver
Récepteur optoélectronique

(43) Veröffentlichungstag der Anmeldung: 09.11.2005
(73) Patentinhaber: Vishay Semiconductor GmbH, 74072 Heilbronn (DE)
(72) Erfinder: Mistele, Thomas, 74360 Ilsfeld (DE); Giebler, Siegfried, 71543 Wüstenrot (DE); Angerstein, Jörg, Dr., 74223 Flein (DE)
(74) Vertreter: Manitz, Finsterwald & Partner GbR

(56) Entgegenhaltungen:
- EP-A- 0 624 962
- DE-A- 4 212 948
- DE-A- 19 652 030
- US-A- 5 623 143

## Beschreibung

Die Erfindung betrifft einen optoelektronischen Empfänger, insbesondere ein Fernsteuer-Empfangsmodul, mit einem lichtempfindlichen Halbleiterbauelement, mehreren Anschlussbeinchen und einem transparenten Gehäuse, wobei das lichtempfindliche Halbleiterbauelement und die Anschlussbeinchen dergestalt in dem Gehäuse vergossen sind, dass die Anschlussbeinchen mit einem jeweiligen freien Ende aus dem Gehäuse herausragen, und wobei die Lichteintrittsfläche des lichtempfindlichen Halbleiterbauelements eine im Wesentlichen rechteckige Form besitzt. Ein solcher Empfänger ist beispielsweise aus DE 196 52 030 A1 bekannt.

Ein derartiger optoelektronischer Empfänger wird beispielsweise im Zusammenhang mit Infrarot-Fernsteuerungen eingesetzt, um optische Signale, die von einem zugeordneten Sender ausgestrahlt werden, innerhalb des lichtempfindlichen Halbleiterbauelements in photoelektrische Empfangssignale umzuwandeln. Das lichtempfindliche Halbleiterbauelement ist mit den Anschlussbeinchen des Empfängers direkt oder indirekt verbunden, beispielsweise um mit der Betriebsspannung versorgt zu werden oder um die Empfangssignale weiterleiten zu können. Die freien Enden der Anschlussbeinchen verlaufen üblicherweise im Wesentlichen parallel zueinander, so dass unterschiedliche Möglichkeiten der Montage des Empfängers für verschiedene Anwendungen bestehen.

Bei dem lichtempfindlichen Halbleiterbauelement handelt es sich beispielsweise um eine Photodiode oder einen Phototransistor. Da üblicherweise eine Vielzahl derartiger Bauelemente gleichzeitig in einem orthogonalen Raster auf einem gemeinsamen Halbleitersubstrat hergestellt wird, besitzt die Lichteintrittsfläche des-lichtempfindlichen Halbleiterbauelements typischerweise eine rechteckige, insbesondere eine quadratische Form, wobei Abweichungen beispielsweise aufgrund von Diffusionseffekten des Dotierungsstoffs resultieren können. Die Ebene der Lichteintrittsfläche des optoelektronischen Empfängers wird üblicherweise durch eine X-Achse und eine Y-Achse charakterisiert, wobei die Y-Achse parallel zu der Erstreckungsrichtung der freien Enden der Anschlussbeinchen verläuft und die X-Achse sich senkrecht hierzu erstreckt.

Die vorgenannten Fernsteuerungen sollen mitunter über große Distanzen funktionsfähig und in einem breiten Winkelbereich empfindlich sein, und sie sollen hinsichtlich der verwendeten optischen Strahlung ein hohes Signal/Rausch-Verhältnis besitzen. Hierfür ist es zweckdienlich, die Lichteintrittsfläche, d.h. die für die Detektion der optischen Strahlung wirksame Oberfläche des lichtempfindlichen Halbleiterbauelements, vergleichsweise groß auszubilden. Dies führt jedoch zu einer unerwünschten Verteuerung des lichtempfindlichen Halbleiterbauelements und somit des optoelektronischen Empfängers. Außerdem vergrößert sich hierdurch die Baugröße des Empfängers in unerwünschter Weise. Ferner erhöht sich die parasitäre Kapazität des lichtempfindlichen Halbleiterbauelements.

Es ist eine Aufgabe der Erfindung, einen optoelektronischen Empfänger zu schaffen, der bei kostengünstiger Herstellung und kompakter Bauform für die erwünschte Anwendung eine hohe Empfindlichkeit gegenüber der verwendeten optischen Strahlung besitzt.

Diese Aufgabe wird durch einen optoelektronischen Empfänger mit den Merkmalen des Anspruchs 1 gelöst, und insbesondere dadurch, dass die Seitenkanten der Lichteintrittsfläche des lichtempfindlichen Halbleiterbauelements bezüglich der Erstreckungsrichtung der freien Enden der Anschlussbeinchen einen Winkel von ungefähr 45° einnehmen.

Bei dem erfindungsgemäßen optoelektronischen Empfänger ist also die rechteckige oder quadratische Form der Lichteintrittsfläche des lichtempfindlichen Halbleiterbauelements bezüglich der Erstreckungsrichtung der aus dem Gehäuse herausragenden Anschlussbeinchen um einen Winkel von ungefähr 45° verdreht. Hierdurch wird bei einer vergleichsweise geringen Größe der Lichteintrittsfläche des lichtempfindlichen Halbleiterbauelements eine für viele Anwendungen ausreichend hohe Empfindlichkeit entlang der vorgenannten X-Achse und Y-Achse erzielt (hohe so genannte X/Y-Empfindlichkeit).

Im Rahmen der Erfindung wurde erkannt, dass für viele Anwendungen eine hohe Empfindlichkeit des optoelektronischen Empfängers lediglich innerhalb einer einzigen bestimmten Raumebene, insbesondere einer horizontalen Raumebene erforderlich ist. Bezogen auf die Lichteintrittsfläche des lichtempfindlichen Halbleiterbauelements entspricht dies einer hohen Empfindlichkeit entlang einer einzigen Achse entlang der Lichteintrittsfläche. Der optoelektronische Empfänger wird an einem elektrischen Gerät, das Fernsteuersignale empfangen soll, üblicherweise dergestalt montiert, dass die Anschlussbeinchen entweder zur Horizontalen oder zur Vertikalen parallel verlaufen. Dies bedeutet, dass auch die genannte X-Achse und Y-Achse der Lichteintrittsfläche parallel zur Horizontalen oder zur Vertikalen verlaufen. Aufgrund der um 45° verdrehten Ausrichtung der Lichteintrittsfläche erstrecken sich bei dem erfindungsgemäßen Empfänger somit nicht die Seitenkanten, sondern die - vergleichsweise längeren - Diagonalen der Lichteintrittsfläche parallel zu der Horizontalen und Vertikalen. Die hohe X/Y-Empfindlichkeit des lichtempfindlichen Halbleiterbauelements führt demzufolge zu einer vorteilhaft hohen Empfindlichkeit in der praktischen Anwendung des Empfängers.

Zusammengefasst ist es also wichtig, dass sich nicht die Seitenkanten, sondern die Diagonalen der Lichteintrittsfläche des lichtempfindlichen Halbleiterbauelements parallel und senkrecht zu der Erstreckungsrichtung der freien Enden der Anschlussbeinchen erstrecken. Hierdurch wird, wie erläutert, bei einer vergleichsweise geringen Lichteintrittsfläche eine für viele praktische Anwendungen ausreichend hohe Empfindlichkeit gegenüber der verwendeten optischen Strahlung erreicht. Das lichtempfindliche Halbleiterbauelement kann dementsprechend vergleichsweise kostengünstig hergestellt werden, und der optoelektronische Empfänger besitzt eine vorteilhaft geringe Baugröße.

Selbstverständlich kann die Erfindung unabhängig davon realisiert werden, ob das lichtempfindliche Halbleiterbauelement im sichtbaren, im infraroten oder im ultravioletten Spektralbereich detektiert.

Es ist bevorzugt, wenn die Lichteintrittsfläche des lichtempfindlichen Halbleiterbauelements sich innerhalb einer Ebene erstreckt, die parallel zu der Ebene verläuft, die von den freien Enden der Anschlussbeinchen aufgespannt wird. Dadurch ist ein besonders flacher Aufbau des optoelektronischen Empfängers möglich. Alternativ hierzu kann die Lichteintrittsfläche jedoch auch senkrecht zu der von den Anschlussbeinchen aufgespannten Ebene verlaufen, insbesondere wenn die Anschlussbeinchen innerhalb oder außerhalb des Gehäuses um 90° gebogen sind.

Gemäß einer vorteilhaften Weiterbildung besitzt das Gehäuse einen Linsenabschnitt, der an einem ersten Bereich des lichtempfindlichen Halbleiterbauelements eine Erhöhung des Gehäuses bezüglich der Lichteintrittsfläche bildet und sich ab einem anschließenden zweiten Bereich des lichtempfindlichen Halbleiterbauelements auf gleich bleibender Höhe bezüglich der Lichteintrittsfläche erstreckt. Mit anderen Worten ist ein lang gestreckter Linsenabschnitt vorgesehen, der bezüglich der Lichteintrittsfläche in dem ersten Bereich zunächst ansteigt und anschließend in dem zweiten Bereich und gegebenenfalls darüber hinaus parallel zu der Lichteintrittsfläche verläuft.

Diese Ausgestaltung des Gehäuses hat den Vorteil, dass für drei der vier genannten X/Y-Richtungen des Empfängers eine konvexe Wölbung verwirklicht und somit eine gute Linsenwirkung erzielt werden kann. Hierdurch wird die erläuterte X/Y-Empfindlichkeit des optoelektronischen Empfängers begünstigt. Gleichzeitig ist eine besonders einfache Fertigung des Gehäuses möglich, beispielsweise durch Formgießen oder Spritzgießen eines thermoplastischen oder duroplastischen Kunststoffs. Da aufgrund des lang gestreckten Linsenabschnitts an einer Seite des Gehäuses keine Schrägen erzeugt werden müssen, kann das verwendete Gießwerkzeug vorteilhaft einfachen Aufbau besitzen.

Besonders einfach ist die Fertigung des Gehäuses, wenn der Linsenabschnitt sich ab dem genannten zweiten Bereich des lichtempfindlichen Halbleiterbauelements auf gleich bleibender Höhe bis zu derjenigen Seite des Empfängers erstreckt, an der die Anschlussbeinchen aus dem Gehäuse herausragen. Diese Seite bildet die Rückseite des Gehäuses, und der Linsenabschnitt erstreckt sich also bis zu dieser Rückseite.

Alternativ zu dieser besonderen Ausgestaltung des Linsenabschnitts kann das Gehäuse jedoch auch einen runden, d.h. kugelsegmentförmigen oder halbkugelförmigen, oder einen ovalen Linsenabschnitt besitzen.

Gemäß einer weiteren vorteilhaften Weiterbildung besitzt der optoelektronische Empfänger zusätzlich einen Steuerschaltkreis, wobei das lichtempfindliche Halbleiterbauelement mit dem Steuerschaltkreis zur Übertragung von Empfangssignalen mittels einer Signalleitung verbunden ist, und der optoelektronische Empfänger besitzt ferner wenigstens einen Abschirm-Bonddraht, der quer zu der Signalleitung verläuft, die Signalleitung übergreift und an beiden Enden mit einem Konstantpotentialanschluss verbunden ist.

Bei der genannten Weiterbildung bewirken der oder die Abschirm-Bonddrähte eine wirkungsvolle und einfach zu bewerkstelligende Abschirmung der Signalleitung gegenüber äußeren elektromagnetischen Störungen, die beispielsweise von in der Nähe befindlichen Schaltnetzteilen herrühren können. Das Anbringen des oder der genannten Abschirm-Bonddrähte ist bei dem erfindungsgemäßen Empfänger mit der um 45° verdrehten Lichteintrittsfläche besonders vorteilhaft. Die genannte Signalleitung kann nämlich durch einen Signal-Bonddraht zwischen dem Steuerschaltkreis und einem Eckbereich der Lichteintrittsfläche des lichtempfindlichen Halbleiterbauelements verwirklicht werden, so dass der oder die Abschirm-Bonddrähte den betreffenden Eckbereich der Lichteintrittsfläche mit dem hieran befestigten Signal-Bonddraht wirkungsvoll überspannen können.

Weitere Ausführungsformen der Erfindung sind in den Unteransprüchen genannt.

Die Erfindung wird nachfolgend lediglich beispielhaft unter Bezugnahme auf die Zeichnungen erläutert.
- Fig. 1: zeigt eine Seitenansicht einer ersten Ausführungsform eines optoelektronischen Empfängers.
- Fig. 2: zeigt eine Draufsicht der Ausführungsform gemäß Fig. 1.
- Fig. 3: zeigt eine Vorderansicht des Gehäuses der Ausführungsform gemäß Fig. 1.
- Fig. 4: zeigt eine Detailansicht der Anordnung von Photodiode und Steuerschaltkreis gemäß Fig. 2.
- Fig. 5: zeigt eine Seitenansicht einer weiteren Ausführungsform.

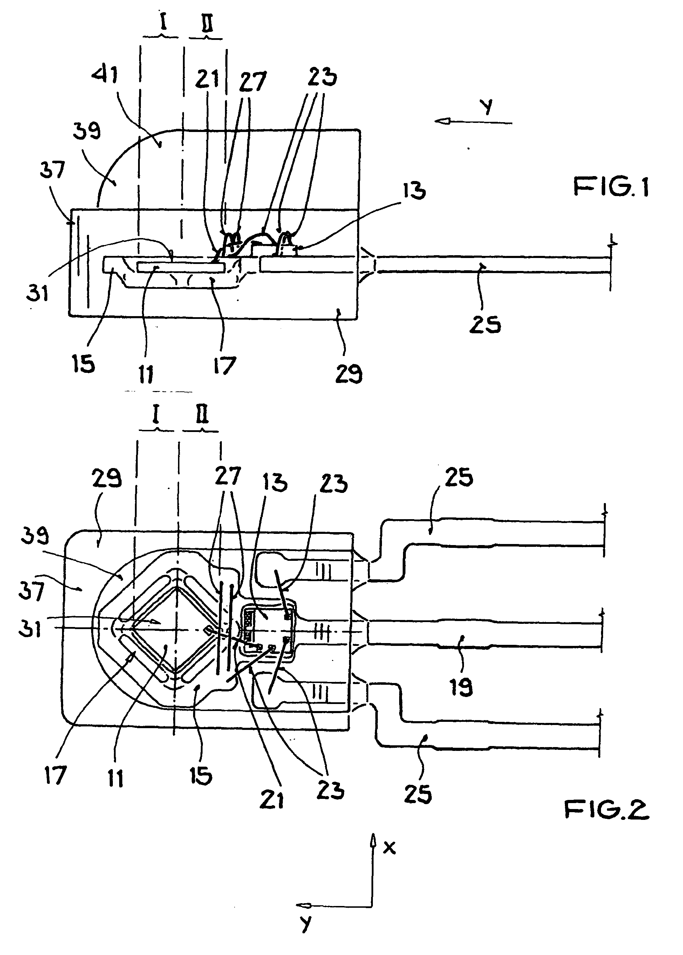

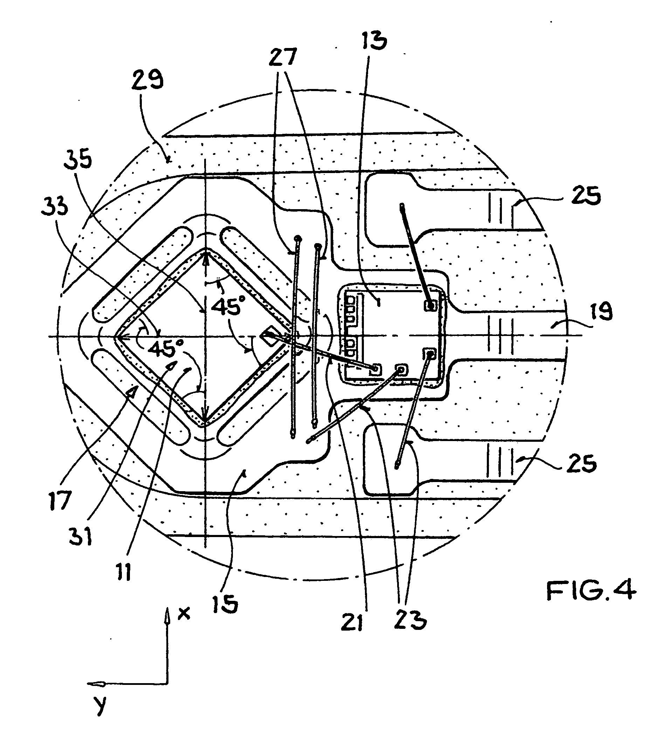

Der in den Fig. 1 bis 4 gezeigte optoelektronische Empfänger besitzt eine als lichtempfindliches Halbleiterbauelement dienende Silizium-Photodiode 11 sowie einen Steuerschaltkreis 13, die auf einem Masse-Leiterstreifen 15 aus Metall angeordnet, beispielsweise aufgeklebt sind. Im Bereich der Photodiode 11 besitzt der Masse-Leiterstreifen 15 eine wannenförmige Vertiefung 17, in die die Photodiode 11 eingesetzt ist. An dem der Vertiefung 17 gegenüber liegenden Ende ist der Masse-Leiterstreifen 15 als ein Masse-Anschlussbeinchen 19 ausgebildet.

Die Photodiode 11 und der Steuerschaltkreis 13 sind mittels eines Signal-Bonddrahts 21 miteinander verbunden, wobei die Photodiode 11 und der Steuerschaltkreis 13 dergestalt konfiguriert sind, dass der Signal-Bonddraht 21 zur Übertragung der Empfangssignale der Photodiode 11 an den Steuerschaltkreis 13 dient.

Weitere Bonddrähte 23 verbinden den Steuerschaltkreis 13 mit dem Masse-Leiterstreifen 15 und jeweils mit zwei äußeren Anschlussbeinchen 25. Eines dieser Anschlussbeinchen 25 kann beispielsweise zur Versorgung des Empfängers mit der Betriebsspannung dienen, während das andere Anschlussbeinchen 25 als Signalausgang dient.

Ferner sind zwei Abschirm-Bonddrähte 27 vorgesehen, die jeweils an beiden Enden mit dem Masse-Leiterstreifen 15 verbunden sind und die den Signal-Bonddraht 21 überqueren. Die beiden Abschirm-Bonddrähte 27 verlaufen in der Draufsicht gemäß Fig. 2 und 4 schräg zu dem Signal-Bonddraht 21 und parallel zueinander.

Die genannten Bauteile sind in einem gemeinsamen Gehäuse 29 vergossen, wobei die Anschlussbeinchen 19, 25 aus dem Gehäuse herausragen. Die freien Enden der Anschlussbeinchen 19, 25 verlaufen parallel zueinander entlang einer Richtung Y. Das Gehäuse 29 ist im infraroten Spektralbereich, für den auch die Photodiode 11 empfindlich ist, transparent.

Wie aus der jeweiligen Draufsicht gemäß Fig. 2 und 4 ersichtlich ist, besitzt die Lichteintrittsfläche 31 der Photodiode 11 eine quadratische Form. Die Lichteintrittsfläche 31 erstreckt sich innerhalb derjenigen Ebene, die von den drei freien Enden der Anschlussbeinchen 19, 25 aufgespannt wird. Die vier Seitenkanten der quadratischen Lichteintrittsfläche 31 sind bezüglich der Erstreckungsrichtung Y der freien Enden der Anschlussbeinchen 19, 25 um einen Winkel von jeweils 45° verdreht. Somit verläuft die eine Diagonale 33 der quadratischen Lichteintrittsfläche 31 genau parallel zu der Erstreckungsrichtung Y der freien Enden der Anschlussbeinchen 19, 25, während die andere Diagonale 35 der Lichteintrittsfläche 31 parallel zu einer Richtung X verläuft, die sich senkrecht zu der Richtung Y erstreckt.

Der in den Fig. 1 bis 4 gezeigte optoelektronische Empfänger dient als Signalempfänger einer Infrarot-Fernsteuerung. Hierfür wandelt die Photodiode 11 die im Infraroten empfangenen optischen Signale in elektrische Signale um, die über den Signal-Bonddraht 21 zunächst an den Steuerschaltkreis 13 weitergeleitet werden. Dort erfolgt eine erste Signalverarbeitung, insbesondere eine Filterung, Formung, Verstärkung oder Dekodierung der Empfangssignale oder eine sonstige Steuerung der Photodiode 11. Anschließend werden die derartig vorverarbeiteten Empfangssignale über ein Anschlussbeinchen 25 des Empfängers ausgegeben.

Die Erstreckungsrichtung Y der freien Enden der Anschlussbeinchen 19, 25 gibt üblicherweise die Ausrichtung des gezeigten Empfängers bei dessen Montage beispielsweise an einer Platine eines elektrischen Geräts vor. Üblicherweise wird der Empfänger entweder mit horizontaler oder mit vertikaler Ausrichtung der Anschlussbeinchen 19, 25 montiert. Aufgrund der erläuterten, um 45° verdrehten Anordnung der Lichteintrittsfläche 31 der Photodiode 11 besitzt der Empfänger in beiden Fällen eine vergleichsweise große Empfindlichkeit hinsichtlich der Horizontalebene und der Vertikalebene, da die Diagonalen 33, 35 der Lichteintrittsfläche 31 - und nicht die kürzeren Seitenkanten - parallel zu der Horizontalen bzw. Vertikalen verlaufen. Die hohe Empfindlichkeit bezüglich der Horizontalen und Vertikalen wird mit einer flächenmäßig vergleichsweise kleinen und somit kostengünstigen Photodiode 11 erreicht, und der Empfänger mit dem Gehäuse 29 kann letztlich eine vergleichsweise geringe Baugröße besitzen.

Die bezüglich der Erstreckungsrichtung Y der Anschlussbeinchen 19, 25 um einen Winkel von 45° verdrehte Ausrichtung der Photodiode 11 bringt auch einen Vorteil hinsichtlich der Abschirmung von Störsignalen:

Die Abschirm-Bonddrähte 27 bewirken eine vorteilhafte Abschirmung des Signal-Bonddrahts 21 gegenüber elektromagnetischen Störsignalen, da die Abschirm-Bonddrähte 27 gemeinsam mit dem Masse-Leiterstreifen 15 eine geschlossene Umhüllung des Signal-Bonddrahts 21 bilden. Der Masse-Leiterstreifen 15 ist im Betrieb des optoelektronischen Empfängers auf das elektrische Massepotential des Empfängers gesetzt. Aufgrund des Übergreifens des Signal-Bonddrahts 21 durch die somit ebenfalls auf das Massepotential gesetzten Abschirmbonddrähte 27 werden externe elektromagnetische Störsignale abgeschirmt, die sich anderenfalls ungeschwächt dem entlang des Signal-Bonddrahts 21 geführten Nutzsignal überlagern würden.

Da die Photodiode 11 bezüglich der Erstreckungsrichtung Y der Anschlussbeinchen 19, 25 um einen Winkel von 45° verdreht ist und die Photodiode 11 somit mit einer Ecke ihrer quadratischen Form in Richtung des Steuerschaltkreises 13 weist, kann der Signal-Bonddraht 21 seitens der Photodiode 11 an einem Eckbereich der Lichteintrittsfläche 31 befestigt werden. Hierdurch ist es besonders einfach, die Abschirm-Bonddrähte 27 über den Signal-Bonddraht 21 zu spannen und dennoch an beiden Enden mit dem Masse-Leiterstreifen 15 zu verbinden. Die Abschirm-Bonddrähte 27 müssen hierfür nämlich lediglich den betreffenden Eckbereich der Photodiode 11 bzw. der Lichteintrittsfläche 31 übergreifen, wie insbesondere aus der Draufsicht gemäß Fig. 4 ersichtlich ist.

Darüber hinaus kann die erläuterte Abschirmmaßnahme fertigungstechnisch auf sehr einfache Weise verwirklicht werden, da bei der Herstellung des Empfängers ohnehin Bonddrähte 21, 23 angebracht werden müssen. Das zusätzliche Anbringen der Abschirm-Bonddrähte 27 bedeutet demgegenüber keinen erheblichen Mehraufwand.

Eine weitere Maßnahme zur Abschirmung der Photodiode 11 gegen externe elektromagnetische Störsignale besteht in der Anordnung der Photodiode 11 in der wannenartigen Vertiefung 17 des Masse-Leiterstreifens 15. Der Boden und die Seitenwände der wannenförmigen Vertiefung 17 unterdrücken die von unten und von der Seite einfallende Störstrahlung oder schwächen diese zumindest ab. Ein weiterer Vorteil der Anordnung der Photodiode 11 in der wannenförmigen Vertiefung 17 besteht darin, dass der Signal-Bonddraht 21 einen flachen Verlauf von der Photodiode 11 zu dem Steuerschaltkreis 13 einnehmen kann, so dass das Übergreifen des Signal-Bonddrahts 21 mittels der Abschirm-Bonddrähte 27 noch weiter vereinfacht ist.

Fig. 1 bis 4 zeigen ferner die folgende vorteilhafte Weiterbildung:

Das Gehäuse 29 besitzt einen im Wesentlichen quaderförmigen Grundkörper 37, in dem die Photodiode 11, der Steuerschaltkreis 13 und die Anschlussbeinchen 19, 25 vergossen sind, wobei ein zusätzlicher Linsenabschnitt 39 des Gehäuses 29 an der Oberseite des Grundkörpers 37 angeformt ist. Der Linsenabschnitt 39 bildet an einem ersten, der Vorderseite des Empfängers zugewandten Bereich I der Photodiode 11 eine Erhöhung 41 des Gehäuses 29 bezüglich der Lichteintrittsfläche 31. In einem sich hieran anschließenden zweiten Bereich II der Photodiode 11 erstreckt sich der Linsenabschnitt 39 auf - bezüglich der Lichteintrittsfläche 31 - gleich bleibender Höhe und somit parallel zu der Erstreckungsrichtung Y der Anschlussbeinchen 19, 25 bis zu der Rückseite des Empfängers, an der die freien Enden der Anschlussbeinchen 19, 25 aus dem Gehäuse 29 herausragen (vgl. Seitenansicht gemäß Fig. 1).

Das Gehäuse 29 mit dem erläuterten lang gestreckten Linsenabschnitt 39 lässt sich durch ein Gießverfahren besonders leicht herstellen, da der Empfänger nach dem Gießprozess parallel zu der Richtung Y mit den Anschlussbeinchen 19, 25 voraus aus der Gießform herausgezogen werden kann. Das Gießwerkzeug kann einen besonders einfachen Aufbau besitzen, da die Höhe des Linsenabschnitts 39 bezüglich der Erstreckungsebene der Lichteintrittsfläche 31 und der Anschlussbeinchen 19, 25 sich an der Rückseite des Empfängers, d.h. in der Umgebung der freien Enden der Anschlussbeinchen 19, 25, nicht neuerlich verringert (vgl. Seitenansicht gemäß Fig. 1).

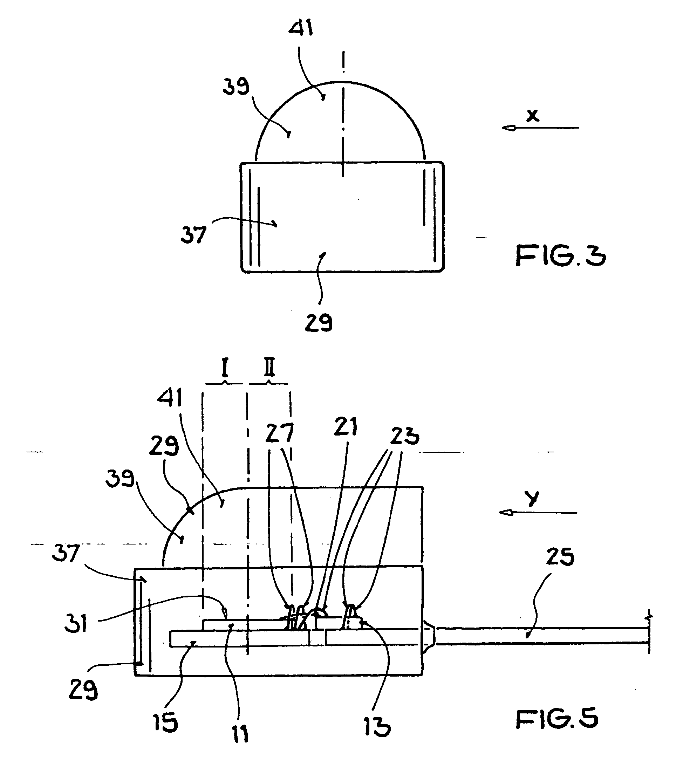

Gleichzeitig bewirkt der Linsenabschnitt 39 für die um 45° verdrehte Photodiode 11 eine ausreichende Linsenwirkung, d.h. eine ausreichende Fokussierung der einfallenden Strahlung auf die Photodiode 11: Der Linsenabschnitt 39 ist nämlich an dem genannten ersten Bereich I der Photodiode 11 entlang einer Querschnittsebene, die senkrecht zu der Lichteintrittsfläche 31 und parallel zu der Erstreckungsrichtung Y der Anschlussbeinchen 19, 25 verläuft (Papierebene der Seitenansicht gemäß Fig. 1), konvex gekrümmt. Ferner ist der Linsenabschnitt 39 auch entlang einer Querschnittsebene, die senkrecht zu der Lichteintrittsfläche 31 und senkrecht zu der Erstreckungsrichtung Y der Anschlussbeinchen 19, 25 verläuft (Papierebene der Frontansicht gemäß Fig. 3), in sämtlichen Bereichen I, II der Photodiode 11 konvex gekrümmt. Somit sind sowohl hinsichtlich der X-, als auch hinsichtlich der Y-Richtung ausreichende Fokussierungseigenschaften gewährleistet.

In der konkreten Ausgestaltung gemäß Fig. 1 bis 4 besitzt der Linsenabschnitt 39 an dem ersten Bereich I der Photodiode 11 die Form eines Kugelsegments (Segmentwinkel von 90°). Anschließend, also ab dem zweiten Bereich II der Photodiode 11, geht der Linsenabschnitt 39 in die Form eines Zylindersegments über (Halbzylinderform), dessen Längsachse parallel zu der Richtung Y verläuft.

Fig. 5 zeigt, dass die erläuterte wannenförmige Vertiefung 17 des Masse-Leiterstreifens 15 nicht zwingend erforderlich ist. Hier sind die Photodiode 11 und der Steuerschaltkreis 13 stattdessen auf gleicher Höhe auf dem Masse-Leiterstreifen 15 angeordnet.

### Bezugszeichenliste

- 11: Photodiode
- 13: Steuerschaltkreis
- 15: Masse-Leiterstreifen
- 17: Vertiefung
- 19: Masse-Anschlussbeinchen
- 21: Signal-Bonddraht
- 23: Bonddraht
- 25: Anschlussbeinchen
- 27: Abschirm-Bonddraht
- 29: Gehäuse
- 31: Lichteintrittsfläche
- 33: Diagonale
- 35: Diagonale
- 37: Grundkörper
- 39: Linsenabschnitt
- 41: Erhöhung

- I: erster Bereich
- II: zweiter Bereich

- X: Richtung
- Y: Richtung

## Patentansprüche

1. Optoelektronischer Empfänger, insbesondere Fernsteuer-Empfangsmodul,
mit einem lichtempfindlichen Halbleiterbauelement (11), mehreren Anschlussbeinchen (19, 25) und einem Gehäuse (29),
wobei das lichtempfindliche Halbleiterbauelement (11) und die Anschlussbeinchen (19, 25) dergestalt in dem Gehäuse (29) vergossen sind, dass die Anschlussbeinchen mit einem jeweiligen freien Ende aus dem Gehäuse herausragen, und
wobei die Lichteintrittsfläche (31) des lichtempfindlichen Halbleiterbauelements (11) eine im Wesentlichen rechteckige Form besitzt,
**dadurch gekennzeichnet,**
**dass** die Seitenkanten der Lichteintrittsfläche (31) des lichtempfindlichen Halbleiterbauelements (11) bezüglich der Erstreckungsrichtung der freien Enden der Anschlussbeinchen (19, 25) einen Winkel von 45° einnehmen.

2. Optoelektronischer Empfänger nach Anspruch 1,
**dadurch gekennzeichnet,**
**dass** die Lichteintrittsfläche (31) des lichtempfindlichen Halbleiterbauelements (11) eine im Wesentlichen quadratische Form besitzt.

3. Optoelektronischer Empfänger nach einem der vorhergehenden Ansprüche,
**dadurch gekennzeichnet,**
**dass** die Lichteintrittsfläche (31) des lichtempfindlichen Halbleiterbauelements (11) sich innerhalb einer Ebene erstreckt, die parallel zu der Ebene verläuft, die von den freien Enden der Anschlussbeinchen (19, 25) aufgespannt wird.

4. Optoelektronischer Empfänger nach einem der vorhergehenden Ansprüche,
**dadurch gekennzeichnet,**
**dass** das Gehäuse (29) einen Linsenabschnitt (39) aufweist, der an einem ersten Bereich (I) des lichtempfindlichen Halbleiterbauelements (11) eine Erhöhung (41) des Gehäuses bildet und sich ab einem anschließenden zweiten Bereich (II) des lichtempfindlichen Halbleiterbauelements auf gleich bleibender Höhe bezüglich der Lichteintrittsfläche (31) des lichtempfindlichen Halbleiterbauelements (11) erstreckt.

5. Optoelektronischer Empfänger nach Anspruch 4,
**dadurch gekennzeichnet,**
**dass** der Linsenabschnitt (39) des Gehäuses (29) sich ab dem zweiten Bereich (II) des lichtempfindlichen Halbleiterbauelements (11) bis zu derjenigen Seite des Empfängers erstreckt, an der die Anschlussbeinchen (19, 25) aus dem Gehäuse herausragen.

6. Optoelektronischer Empfänger nach einem der Ansprüche 4 oder 5,
**dadurch gekennzeichnet,**
**dass** der Linsenabschnitt (39) des Gehäuses (29) an dem ersten Bereich (I) des lichtempfindlichen Halbleiterbauelements (11) entlang einer Querschnittsebene, die senkrecht zu der Lichteintrittsfläche (31) des lichtempfindlichen Halbleiterbauelements (11) und parallel zu der Erstreckungsrichtung der freien Enden der Anschlussbeinchen (19, 25) verläuft, konvex gekrümmt ist,
und/oder
**dass** der Linsenabschnitt (39) entlang einer Querschnittsebene, die senkrecht zu der Lichteintrittsfläche (31) des lichtempfindlichen Halbleiterbauelements (11) und senkrecht zu der Erstreckungsrichtung der freien Enden der Anschlussbeinchen (19, 25) verläuft, konvex gekrümmt ist.

7. Optoelektronischer Empfänger nach einem der Ansprüche 4 bis 6,
**dadurch gekennzeichnet,**
**dass** der Linsenabschnitt (39) des Gehäuses (29) an dem ersten Bereich (I) des lichtempfindlichen Halbleiterbauelements (11) die Form eines Kugelsegments besitzt, und dass der Linsenabschnitt (39) anschließend ab dem zweiten Bereich (II) des lichtempfindlichen Halbleiterbauelements (11) in die Form eines Zylindersegments übergeht, dessen Längsachse parallel zu der Erstreckungsrichtung der freien Enden der Anschlussbeinchen (19, 25) verläuft.

8. Optoelektronischer Empfänger nach einem der Ansprüche 4 bis 7,
**dadurch gekennzeichnet,**
**dass** das Gehäuse (29) einen quaderförmigen Grundkörper (37) aufweist, in dem das lichtempfindliche Halbleiterbauelement (11) und die Anschlussbeinchen (19, 25) vergossen sind, wobei der Linsenabschnitt (39) an dem Grundkörper (37) angeformt ist.

9. Optoelektronischer Empfänger nach einem der vorhergehenden Ansprüche,
**dadurch gekennzeichnet,**
**dass** der optoelektronische Empfänger zusätzlich einen Steuerschaltkreis (13) aufweist, wobei das lichtempfindliche Halbleiterbauelement (11) mit dem Steuerschaltkreis zur Übertragung von Empfangssignalen mittels einer Signalleitung (21) verbunden ist, und
**dass** der optoelektronische Empfänger wenigstens einen Abschirm-Bonddraht (27) aufweist, der quer zu der Signalleitung (21) verläuft, die Signalleitung übergreift und an beiden Enden mit einem Konstantpotentialanschluss (15) verbunden ist.

10. Optoelektronischer Empfänger nach Anspruch 9,
**dadurch gekennzeichnet,**
**dass** der Abschirm-Bonddraht (27) mit dem Konstantpotentialanschluss (15) eine geschlossene Schleife bildet, die die Signalleitung (21) umschließt,
und/oder
**dass** der Abschirm-Bonddraht (27) an beiden Enden mit einem Masse-Leiterstreifen (15) verbunden ist.

11. Optoelektronischer Empfänger nach einem der vorhergehenden Ansprüche,
**dadurch gekennzeichnet,**
**dass** an dem Masse-Leiterstreifen (15) eine wannenförmige Vertiefung (17) ausgebildet ist, und
**dass** das lichtempfindliche Halbleiterbauelement (11) in der Vertiefung (17) angeordnet ist.

## Claims

1. An optoelectronic receiver, in particular a remote control receiver module,
comprising a light-sensitive semiconductor component (11), a plurality of connection legs (19, 25) and a housing (29),
wherein the light-sensitive semiconductor component (11) and the connection legs (19, 25) are potted in the housing (29) such that respective free ends of the connection legs project out of the housing, and
wherein the light entry surface (31) of the light-sensitive semiconductor component (11) has a substantially rectangular shape,
**characterized in that**
the side edges of the light entry surface (31) of the light-sensitive semiconductor element (11) adopt an angle of 45° with respect to the direction of extent of the free ends of the connection legs (19, 25).

2. An optoelectronic receiver in accordance with claim 1, **characterized in that** the light entry surface (31) of the light-sensitive semiconductor element (11) has a substantially square shape.

3. An optoelectronic receiver in accordance with any one of the preceding claims, **characterized in that** the light entry surface (31) of the light-sensitive semiconductor component (11) extends within a plane which extends parallel to the plane set up by the free ends of the connection legs (19, 25).

4. An optoelectronic receiver in accordance with any one of the preceding claims, **characterized in that** the housing (29) has a lens section (39) which forms a raised portion (41) of the housing at a first region (I) of the light-sensitive semiconductor component (11) and which extends, from an adjoining second region (II) of the light-sensitive semiconductor component onward, at a constant level with respect to the light entry surface (31) of the light-sensitive semiconductor component (11).

5. An optoelectronic receiver in accordance with claim 4, **characterized in that** the lens section (39) of the housing (29) extends from the second region (II) of the light-sensitive semiconductor component (11) up to that side of the receiver at which the connection legs (19, 25) project out of the housing.

6. An optoelectronic receiver in accordance with claim 4 or claim 5, **characterized in that** the lens section (39) of the housing (29) is convexly curved at the first region (I) of the light-sensitive semiconductor component (11) along a cross-sectional plane which extends perpendicular to the light entry surface (31) of the light-sensitive semiconductor component (11) and parallel to the direction of extent of the free ends of the connection legs (19, 25); and/or **in that** the lens section (39) is convexly curved along a cross-sectional plane which extends perpendicular to the light entry surface (31) of the light-sensitive semiconductor component (11) and perpendicular to the direction of extent of the free ends of the connection legs (19, 25).

7. An optoelectronic receiver in accordance with any one of the claims 4 to 6, **characterized in that** the lens section (39) of the housing (29) at the first region (I) of the light-sensitive semiconductor component (11) has the shape of a spherical segment; and **in that** the lens section (39) subsequently merges, from the second region (II) of the light-sensitive semiconductor component (11) onward, into the shape of a cylindrical segment whose longitudinal axis extends parallel to the direction of extent of the free ends of the connection legs (19, 25).

8. An optoelectronic receiver in accordance with any one of the claims 4 to 7, **characterized in that** the housing (29) has a base body (37) in the shape of a parallelepiped in which the light-sensitive semiconductor component (11) and the connection legs (19, 25) are potted, with the lens section (39) being molded onto the base body (37).

9. An optoelectronic receiver in accordance with any one of the preceding claims, **characterized in that** the optoelectronic receiver additionally has a control circuit (13), with the light-sensitive semiconductor component (11) being connected to the control circuit by means of a signal lead (21) for the transmission of received signals; and **in that** the optoelectronic receiver has at least one screen bonding wire (27) which extends transversely to the signal lead (21) which engages over the signal lead and is connected to a constant potential terminal (15) at both ends.

10. An optoelectronic receiver in accordance with claim 9, **characterized in that** the screen bonding wire (27) with the constant potential terminal (15) forms a closed loop which surrounds the signal lead (21); and/or **in that** the screening bonding wire (27) is connected at both ends to a ground conductor strip (15).

11. An optoelectronic receiver in accordance with any one of the preceding claims, **characterized in that** a tub-like recess (17) is formed at the ground conductor strip (15); and **in that** the light-sensitive semiconductor component (11) is arranged in the recess (17).

## Revendications

1. Récepteur optoélectronique, en particulier module récepteur de télécommande, comprenant un composant semi-conducteur photosensible (11), plusieurs pattes de raccordement (19, 25) et un boîtier (29),
dans lequel le composant semi-conducteur photosensible (11) et les pattes de raccordement (19, 25) sont intégrés par coulée dans le boîtier (29) de telle manière que les pattes de raccordement dépassent hors du boîtier par une extrémité libre respective, et
dans lequel la surface d'entrée de lumière (31) du composant semi-conducteur photosensible (11) possède une forme sensiblement rectangulaire,
**caractérisé en ce que**
les arêtes latérales de la surface d'entrée de lumière (31) du composant semi-conducteur photosensible (11) font un angle de 45° par rapport à la direction d'extension des extrémités libres des pattes de raccordement (19, 25).

2. Récepteur optoélectronique selon la revendication 1, **caractérisé en ce que** la surface d'entrée de lumière (31) du composant semi-conducteur photosensible (11) possède une forme sensiblement carrée.

3. Récepteur optoélectronique selon l'une des revendications précédentes, **caractérisé en ce que** la surface d'entrée de lumière (31) du composant semi-conducteur photosensible (11) s'étend à l'intérieur d'un plan qui est parallèle au plan défini par les extrémités libres des pattes de raccordement (19, 25).

4. Récepteur optoélectronique selon l'une des revendications précédentes, **caractérisé en ce que** le boîtier (29) présente une portion en lentille (39) qui forme au niveau d'une première zone (I) du composant semi-conducteur photosensible (11) une surélévation (41) du boîtier, et qui s'étend, à partir d'une deuxième zone successive (II) du composant semi-conducteur photosensible, à une hauteur qui reste constante par rapport à la surface d'entrée de lumière (31) du composant semi-conducteur photosensible (11).

5. Récepteur optoélectronique selon la revendication 4, **caractérisé en ce que** la portion en lentille (39) du boîtier (29) s'étend à partir de la seconde zone (II) du composant semi-conducteur photosensible (11) jusqu'au côté du récepteur au niveau duquel les pattes de raccordement (19, 25) dépassent hors du boîtier.

6. Récepteur optoélectronique selon l'une des revendications 4 ou 5, **caractérisé en ce que** la portion en lentille (39) du boîtier (29) est cintrée sous forme convexe au niveau de la première zone (I) du composant semi-conducteur photosensible (11) le long d'un plan de section transversale qui s'étend perpendiculairement à la surface d'entrée de lumière (31) du composant semi-conducteur photosensible (11) et parallèlement à la direction d'extension des extrémités libres des pattes de raccordement (19, 25),
et/ou
**en ce que** la portion en lentille (39) est cintrée sous forme convexe le long d'un plan de section transversale qui s'étend perpendiculairement à la surface d'entrée de lumière (31) du composant semi-conducteur photosensible (11) et perpendiculairement à la direction d'extension des extrémités libres des pattes de raccordement (19, 25).

7. Récepteur optoélectronique selon l'une des revendications 4 à 6, **caractérisé en ce que** la portion en lentille (39) du boîtier (29) possède, au niveau de la première zone (I) du composant semi-conducteur photosensible (11), la forme d'un segment de sphère, et **en ce que** la portion en lentille (39) se transforme ensuite à partir de la seconde zone (II) du composant semi-conducteur photosensible (11) en une forme d'un segment de cylindre, dont l'axe longitudinal s'étend parallèlement à la direction d'extension des extrémités libres des pattes de raccordement (19, 25).

8. Récepteur optoélectronique selon l'une des revendications 4 à 7, **caractérisé en ce que** le boîtier (29) présente un corps de base (37) de forme parallélépipédique dans lequel le composant semi-conducteur photosensible (11) et les pattes de raccordement (19,25) sont intégrés par coulée, la portion en lentille (39) étant conformée sur le corps de base (37).

9. Récepteur optoélectronique selon l'une des revendications précédentes, **caractérisé en ce que** le récepteur optoélectronique comprend additionnellement un circuit de commande (13), ledit composant semi-conducteur photosensible (11) étant raccordé au circuit de commande pour transmettre des signaux reçus au moyen d'une ligne à signaux (21), et **en ce que** le récepteur optoélectronique comporte au moins un fil de bonding de blindage (27) qui s'étend transversalement à la ligne à signaux (21), qui coiffe la ligne à signaux, et qui est relié aux deux extrémités à un raccord à potentiel constant (15).

10. Récepteur optoélectronique selon la revendication 9, **caractérisé en ce que** le fils de bonding de blindage (27) forme avec le raccord à potentiel constant (15) une boucle fermée qui entoure la ligne à signaux (21),
et/ou
**en ce que** le fil de bonding de blindage (27) est relié aux deux extrémités à une bande conductrice de masse (15).

11. Récepteur optoélectronique selon l'une des revendications précédentes, **caractérisé en ce qu'**un renfoncement en forme de cuvette (17) est formé sur la bande conductrice de masse (15), et **en ce que** le composant semi-conducteur photosensible (11) est agencé dans le renfoncement.
